# EUROPÄISCHE PATENTSCHRIFT

(11) **EP 1 182 508 B1**
(45) Veröffentlichungstag und Bekanntmachung des Hinweises auf die Patenterteilung: **12.12.2012**
(21) Anmeldenummer: 01119009.7
(22) Anmeldetag: 07.08.2001
(51) Int. Cl.: G03F 7/20, G03F 9/00, H01J 37/304, H01J 37/317

(54) **Verfahren zum Belichten eines aus mehreren Ebenen bestehenden Layouts auf einem Wafer**
Method of exposing a layout comprising several levels on a wafer
Méthode d'exposition d'un arrangement comportant plusieurs niveaux sur une plaquette semiconductrice

(30) Priorität: 14.08.2000 US 224979 P
(43) Veröffentlichungstag der Anmeldung: 27.02.2002
(73) Patentinhaber: Vistec Electron Beam GmbH, 07745 Jena (DE)
(72) Erfinder: Hahmann, Peter, Dr., 07751 Jena-Drackendorf (DE); Bergmann, Eckart, Dr., 07749 Jena (DE)
(74) Vertreter: Freitag, Joachim

(56) Entgegenhaltungen:
- US-A- 4 451 738
- US-A- 4 812 661
- US-A- 4 845 373
- US-A- 5 264 919
- COANE P ET AL: "ELECTRON BEAM/OPTICAL MIXED LITHOGRAPHY AT HALF-MICRON GROUND RULES" MICROELECTRONIC ENGINEERING, ELSEVIER PUBLISHERS BV., AMSTERDAM, NL, Bd. 5, Nr. 1 - 4, INDEX, 1. Dezember 1986 (1986-12-01), Seiten 133-140, XP000045099 ISSN: 0167-9317

## Beschreibung

Die Erfindung bezieht sich auf ein Verfahren zum Belichten eines aus mehreren Ebenen (Layern) bestehenden Layouts auf einem Wafer, bei dem mindestens eine Ebene photolithographisch und darauf folgend mindestens eine weitere Ebene mit einem Elektronenstrahl belichtet wird und der Wafer bezüglich der vorher photolithographisch belichteten Ebene definiert zur Elektronenstrahlbelichtungsanlage auszurichten ist.

Lithographische Verfahren bei der Herstellung von Wafern erfordern oftmals ein aufeinanderfolgendes Belichten mehrerer, übereinanderliegender Ebenen oder auch nebeneinanderliegender Abschnitte. Dabei ist es wichtig, daß die aufeinanderfolgend belichteten Ebenen exakt zueinander positioniert werden bzw. die nebeneinanderliegenden Abschnitte paßgenau aneinander anschließen. Hierzu sind an den Wafern überlicherweise Justiermarken vorgesehen.

Zur Belichtung von Wafern werden sowohl photolithographische Verfahren als auch elektronenstrahllithographische Verfahren eingesetzt. Gegenüber photolithographischen Verfahren zeichnen sich die elektronenstrahllithographischen Verfahren durch eine höhere Auflösung aus. Jedoch lassen sich mit den herkömmlichen Elektronenstrahlschreibern die Produktionsgeschwindigkeiten von Steppern, die nach dem photolithographischen Prinzip arbeiten, nicht erreichen.

Werden gleichzeitig eine hohe Auflösung und eine hohe Produktivität gefordert, so bieten sogenannte Mix-und-Match-Belichtungen in vielen Fällen einen Ausweg. Das bedeutet, daß Stepper den größten Teil der Lithographie erledigen und fast alle Schichten bzw. Ebenen eines Layouts belichten. Lediglich für Ebenen mit einer hohen Auflösung wird die Elektronenstrahllithographie herangezogen. Entweder werden kritische Ebenen (Gate-Ebenen) mit geringerer Belegungsdichte als Ganzes belichtet. Oder es werden die Teile eines Layouts, die eine hohe Auflösung erfordern, herausgefiltert (Intra-Level-Mix-und-Match) und nur diese mit Hilfe der Elektronenstrahllithographie strukturiert. In beiden Fällen ist das Messen der Justiermarken von besonderer Bedeutung.

Diese Justiermarken sind jedoch zumeist verhältnismäßig klein, so daß sie nicht ohne weiteres aufgefunden werden können. Vielmehr werden dazu in der Praxis mehrere Schritte benötigt. Bei einem bekannten Verfahren erfolgt nach einer Grobausrichtung des Wafers, beispielsweise durch eine Orientierung an dessen geometrischen Rändern, ein Zwischenschritt mit Hilfe erster Marken, die im Folgenden auch als Global-Alignment-Marken bezeichnet werden, bevor die eigentliche Feinausrichtung anhand der Justiermarken erfolgt. Einer der ersten wichtigen Schritte im Verlauf eines Belichtungsverfahrens ist daher das Global-Alignment, d. h. das Ausrichten des Wafers mit Hilfe der ersten Marken. Deren Größe hängt von der bei der Grobausrichtung erreichbaren Genauigkeit ab. Zumeist werden erste Marken mit einer Ausdehnung von typischerweise 0,5 mm bis 1 mm als Suchstrukturen für das Global-Alignment benutzt, um im weiteren Verlauf die viel feineren Justiermarken finden zu können.

In der Praxis wird hierzu in dem Zwischenschritt die Position mindestens einer ersten Marke bestimmt. Mit Hilfe einer Koordinatentransformation läßt sich dann die Position der Justiermarken besser ermitteln, so daß diese in einem kleinen Suchfeld aufgefunden und für die eigentliche Ausrichtung eines Bildfeldes oder Chips auf dem Wafer zu dem jeweiligen Lithographiegerät ausgerichtet werden können.

Häufig werden in der Elektronenstrahllithographie für das Global-Alignment Marken in Form von Kreuzen mit einer Ausdehnung von 1 bis 2 mm genutzt. Die Auswertealgorithmen setzen zumeist voraus, daß sich die Kreuze in einer ungestörten Umgebung befinden, d. h. keine anderen Marken oder ähnlich Strukturen in unmittelbarer Umgebung der Kreuze liegen, da andernfalls der Auswertealgorithmus gestört wird.

Zum Auffinden dieser Marken werden bei den bekannten Verfahren mit dem Elektronenstrahl zunächst Scanns in einer ersten Richtung durchgeführt. Dazu werden die von dem Wafer rückgestreuten Elektronen erfaßt. Ein Auswertealgorithmus bestimmt, ob bei dem jeweiligen Scannvorgang die Marke getroffen wurde. Sofern dies der Fall ist, wird deren Position bestimmt. In analoger Weise wird anschließend in einer zweiten Richtung verfahren, wodurch letztlich die Position der Marke erhalten wird.

Das komplette Global-Alignment mißt die Positionen mehrerer erster Marken und berechnet die notwendigen Transformationen für eine Relativbewegung zwischen dem Wafer und der Lithographieanlage, beispielsweise von Koordinaten eines Tisches, auf dem der Wafer abgelegt ist, hinsichtlich Translation, Rotation und Skalierung, um die Justiermarken zu finden.

In der US 4,812,661 A ist ein Verfahren zur hybrid-integrierten Schaltkreislithographie offenbart, bei dem eine elektronenstrahllithographische Belichtung zu vorhandenen optisch erzeugten lithographischen Strukturen ausgerichtet wird, indem die im optischen lithographischen Prozess erzeugten Marken, die spezifisch für die Elektronenstrahllithografie in Form von Kreuzen, Rahmen oder L-Form erzeugt wurden, entweder zweistufig bei stationärem Tisch mit abgelenktem Elektronenstrahl und bei stationärem Elektronenstrahl mit im Markenbereich verfahrenem Tisch oder als gemischte Daten bei sequenziell verfahrenem Tisch und abgelenktem Elektronenstrahl erfasst werden. Mit diesen Datensätzen wird dann das Belichtungsmuster für die Elektronenstrahlbelichtung modifiziert, um diese mit dem bereits vorhandenen photolithographischen Muster zur Deckung zu bringen.

Davon ausgehend liegt der Erfindung die Aufgabe zugrunde, ein Verfahren der eingangs genannten Art so zu verbessern, daß die Ausrichtung der Wafer vereinfacht wird und dadurch ein höherer Durchsatz an Waferbelichtungen je Zeiteinheit erreichbar ist.

Diese Aufgabe wird erfindungsgemäß durch die Merkmale des Anspruchs 1 gelöst. Vorteilhafte Gestaltungen und Ergänzungen sind in den untergeordneten Ansprüchen spezifiziert.

Dadurch sind die Marken, die im Stand der Technik auf dem Wafer speziell für die Elektronenstrahlbelichtung vorzusehen waren, nicht mehr erforderlich. Mit anderen Worten: Das erfindungsgemäße Verfahren ist vorteilhafterweise nicht mehr an spezielle Markengeometrien gebunden, sondern es lassen sich dem Global-Alignment die verschiedensten Strukturmerkmale zugrunde legen, die nahezu willkürlich aus einer Ebene, die bereits belichtet wurde, ausgewählt werden können. Somit ist der Wafer an jeder beliebigen Struktur auf dem Wafer in der Elektronenstrahlbelichtungsanlage ausrichtbar und der Wafer braucht keine separaten, nur der Ausrichtung in der Elektronenstrahlbelichtungsanlage dienenden Strukturen aufzuweisen.

Außerdem können vorteilhafterweise nicht nur ausgewählte Strukturmerkmale aus einer anderen Ebene, sondern auch Marken zur Ausrichtung genutzt werden, die ursprünglich gar nicht speziell für die Elektronenstrahlbelichtung auf den Wafer aufgebracht worden sind. Während bisher für photolithographische Verfahren und elektronenstrahllithographische Verfahren verschiedene Markengeometrien verwendet werden mußten, ist es in dieser besonderen Anwendung des erfindungsgemäßen Verfahrens nun möglich, für beide Belichtungsverfahren gemeinsame Global-Alignment-Marken zur Ausrichtung zu nutzen.

Weiterhin können die üblicherweise bei der Elektronenstrahllithographie oder auch bei der sogenannten Mix-und-Match-Lithographie ohnehin vorhandenen Einrichtungen genutzt werden. Dies betrifft insbesondere die Ablenkeinrichtung für den Elektronenstrahl, die Einrichtungen zum Detektieren von rückgestreuten Elektronen und zur Analog-Digital-Wandlung der dabei erfaßten Signalkurven sowie die Einrichtungen zum Speichern und Bearbeiten von Daten.

In einer bevorzugten Ausgestaltung der Erfindung ist vorgesehen, den Wafer zunächst grob so zur Elektronenstrahlbelichtungsanlage zu positionieren, daß sich ein Flächenabschnitt der vorher photolithographisch belichteten Ebene, der die ausgewählten Strukturmerkmale enthält, im Ablenkbereich des Elektronenstrahles befindet, dann der Flächenabschnitt in x- und y-Richtung mit dem Elektronenstrahl spotweise abgetastet wird, die von den einzelnen Spots rückgestreute Strahlung detektiert und aus den Intensitäten der von den einzelnen Spots rückgestreuten Strahlung ein Ist-Datensatz gewonnen wird, der einem Rasterbild dieses Flächenabschnittes bei Ist-Position des Wafers entspricht, der Ist-Datensatz mit einem gespeicherten Soll-Datensatz verglichen wird, der dem Rasterbild (Template) desselben Flächenabschnittes bei Soll-Position des Wafers entspricht, aus der Abweichung der beiden Datensätze Informationen über die Abweichung der Ist-Position von der Soll-Position abgeleitet werden, anhand dieser Informationen eine Positionsveränderung des Wafers zwecks Annäherung der Ist-Position an die Soll-Position veranlaßt wird, danach erneut ein Ist-Datensatz gewonnen und mit dem Soll-Datensatz verglichen wird und gegebenenfalls die Gewinnung eines Ist-Datensatzes und der Vergleich mit dem Soll-Datensatz sooft wiederholt werden, bis keine Abweichung mehr festgestellt wird.

So ist es möglich, den Ausgleich einer Lageabweichung nach der Bestimmung der Position der ausgewählten Strukturmerkmale vorzunehmen, wodurch sich das erfindungsgemäße Verfahren gut zu einer automatisierten Ausrichtung eines Wafers nutzen läßt.

Bevorzugt werden die bei der spotweisen Abtastung des Flächenabschnitts erhaltenen Signalkurven digitalisiert. Die Abspeicherung des Rasterbildes erfolgt dann ebenfalls in digitaler Form, wodurch die Speicherung und weitere Verarbeitung gut möglich ist.

Wie bereits oben erläutert, ist das erfindungsgemäße Verfahren nicht auf die Verwendung spezieller Marken oder Strukturen als Basis für die Ausrichtung beschränkt. So kann in einer vorteilhaften Ausgestaltung der Erfindung der Soll-Datensatz mittels eines bereits belichteten Wafers gewonnen werden, wobei zunächst der Wafer und die Elektronenstrahlbelichtungsanlage solange relativ zueinander verschoben werden, bis sich die ausgewählten Strukturmerkmale in der Soll-Position befinden und anschließend ein dem Rasterbild des Flächenabschnittes mit diesen Strukturmerkmale entsprechender Datensatz erfaßt und gespeichert wird. Auf diese Weise lassen sich im Prinzip beliebige charakteristische Strukturmerkmale als Erkennungsmuster verwenden. Eine Elektronenstrahlbelichtungsanlage, in die eine nach dem Verfahren arbeitende Software implementiert ist, kann dadurch sehr flexibel verwendet werden, wodurch unterschiedlichste Strukturmerkmale als Global-Alignment-Marken auswählbar sind.

Alternativ hierzu kann der Soll-Datensatz auch aus elektronisch vorliegenden Strukturdaten der photolithographisch zu belichtenden Ebene entnommen und als Erkennungsmuster gespeichert werden. So ist es beispielsweise denkbar, die entsprechende Geometrie mit einem Grafikprogramm zu generieren und in das Format des Rasterbildes zu übersetzen.

Als charakteristische Strukturmerkmale können aber beispielsweise auch weiterhin die bisher für die Ausrichtung in einem Elektronenstrahlgerät verwendeten Marken oder auch andere, zu diesem Zweck gesondert auf den Wafer aufgebrachte geometrische Strukturen verwendet werden.

Erfindungsgemäß ist die Nutzung eines charakteristischen Strukturabschnitts aus einer bereits belichteten Ebene, weil die Aufbringung gesonderter Marken in diesem Fall vollständig entfallen kann. Charakteristisch bedeutet in diesem Zusammenhang, daß wenigstes der Bereich in unmittelbarer Umgebung des Strukturabschnitts frei von ähnlichen Strukturen ist.

Der für die Positionsbestimmung des Wafers untersuchte Strukturabschnitt sollte vorzugsweise eine Größe im Bereich bis 2000 µm x 2000 µm haben. Bezogen auf eine solche Fläche sollte die Abtastung mit 20 x 20 bis 1000 x 1000 Spots erfolgen.

In einer weiteren vorteilhaften Ausgestaltung wird bei dem rasterförmigen Abtasten des Flächenabschnitts zur Erfassung des Rasterbildes mit dem Elektronenstrahl eine Stempelkette auf das Substrat aufgebracht. Dabei liegt die Schrittweite des Elektronenstrahls im Bereich von 20 nm bis 5 µm. Die dabei über die rückstreuenden Elektronen erhaltenen Rasterbildes gewährleisten einerseits eine ausreichende Datenmenge zum Auffinden der ausgewählten Strukturmerkmale in dem Rasterbild mit Methoden der Bilddatenverarbeitung, andererseits eine verhältnismäßig geringe Rechenzeit, so daß die gesuchte Struktur schnell aufgefunden werden kann. Für das Auffinden und die Bestimmung einer etwaigen Lageabweichung sind Zeiten unter 60 Sekunden je Rasterbild möglich.

Auch kann bei dem rasterförmigen Abtasten der Flächenabschnitt in Mikrofelder aufgeteilt werden, die einzeln abgetastet und zwecks Auswertung zu einem Gesamtbild zusammengesetzt werden. Bevorzugt erfolgt die Aufteilung in Mikrofelder mit einer maximalen Größe von jeweils 60 x 60 Spots. Dies ist bei einer Speicherung der Bilddaten in digitaler Form ohne größere Probleme möglich. Hierdurch ergeben sich insbesondere bei hierarchisch aufgebauten Zwei-Kanal-Elektronenstrahl-Ablenksystemen Vorteile bei der Bildaufnahme, da zunächst den Mikrofeldern entsprechende Teilbilder mit Hilfe des untergeordneten Sub-Reflektionssystems aufgenommen werden können. Dies ist für eine hohe Bildaufnahmegeschwindigkeit günstig.

Eine geeignete Hardware wird in "Evaluation of Fine Pattern Definition with Electron-Beam Direct Writing Lithography", SPIE, 3997, S. 646 ff, 2000, beschrieben. Der Inhalt dieser Veröffentlichung wird in die vorliegende Anmeldung mit einbezogen.

Dem Global-Alignment nach dem erfindungsgemäßen Verfahren kann eine Feinausrichtung des Wafers anhand von auf dem Wafer vorhandenen Justiermarken nachgeordnet werden. Dabei kommen Verfahrensschritte zur Anwendung, wie sie bereits im Stand der Technik üblich sind. Der Ausgleich einer Lageabweichung in bezug auf die Referenzposition kann dabei in das Anfahren eines Suchfeldes, in dem eine Justiermarke vermutet wird, durch eine entsprechende Korrektur der Ansteuerbewegung für das Suchfeld integriert werden. Anhand der Justiermarke erfolgt dann die Feinausrichtung des betreffenden Bildfeldes oder Chips und damit des Wafers zu der Elektronenstrahllithographieanlage.

Nachfolgend wird die Erfindung anhand eines bevorzugten Ausführungsbeispiels im Zusammenhang mit Zeichnungen näher erläutert. Die Zeichnungen zeigen in:
- Fig.1: für das Global-Alignment ausgewählte charakteristische Strukturmerkmale, die sich von ihrer Umgebung unterscheiden, aufgenommen mit Hilfe eines Detektors für reflektierte bzw. rückgestreute Elektronen wobei die hellen senkrechten Linien andeuten, daß das Gesamtbild aus mehreren, streifenförmigen Mikrofeldern zusammengesetzt wurde,
- Fig.2: ein Rasterbild auf Basis eines Soll-Datensatzes, der aus den in Fig.1 gezeigten Strukturmerkmalen abgeleitet ist,
- Fig.3: ein Rasterbild auf Basis eines Soll-Datensatzes, der mittels eines Grafikprogrammes erzeugt wurde,
- Fig.4: die charakteristischen Strukturmerkmale aus Fig.1, aufgenommen mit Hilfe eines Detektors für rückgestreute bzw. reflektierte Elektronen nach einem Ausgleich einer Lageabweichung zwischen dem Wafer und einer Elektronenstrahlvorrichtung in bezug auf eine Referenzposition, d. h. nach einer Justierung,
- Fig.5: Beispiel eines Suchbildes,
- Fig.6: Wafer mit Strukturen.

Zum Ausrichten eines zu belichtenden Wafers in einer Vorrichtung für die Elektronenstrahllithographie wird dieser zunächst grob zu der Vorrichtung ausgerichtet. Die Orientierung erfolgt dabei beispielsweise an den geometrischen Ränder des Wafers. Hierbei realisierbare Lagegenauigkeiten liegen im Bereich von etwa 0,2 mm bis 2 mm. Für eine Positionierung des Elektronenstrahls mit einer Genauigkeit im µm-Bereich ist jedoch eine genauere Lagezuordnung zwischen dem Wafer und der Elektronenstrahlanlage erforderlich.

Dies wird erfindungsgemäß mit ausgewählten, auf einer anderen Ebene (Layer) vorher photolithographisch belichteten Strukturmerkmalen sowie mit zusätzlichen Justiermarken erreicht. Die ausgewählten Strukturmerkmale besitzen dabei eine größere Ausdehnung als die Justiermarken. Ihr wesentlicher Zweck liegt darin, das Auffinden der Justiermarken zu ermöglichen.

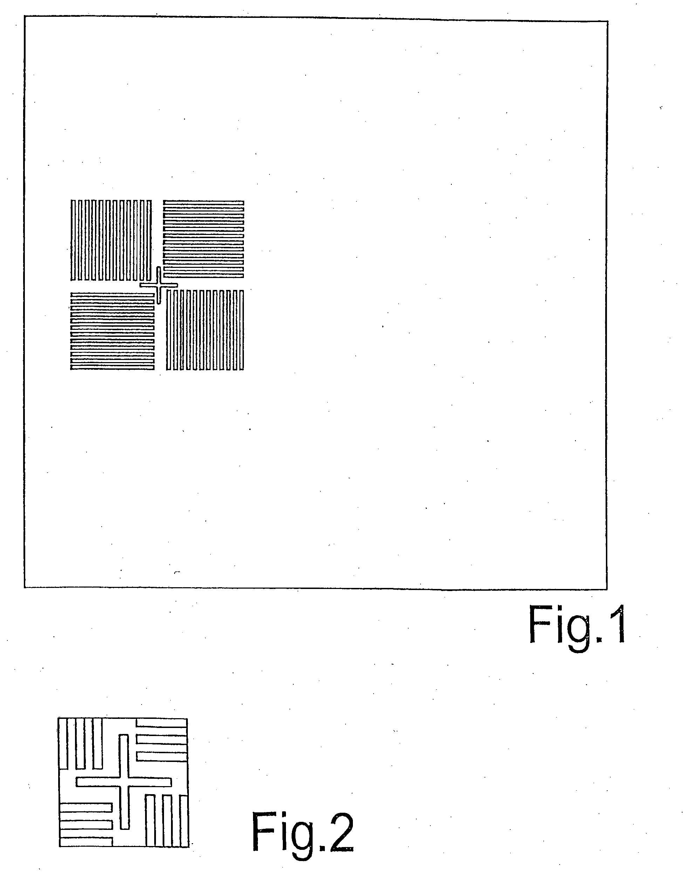

Ein Beispiel für ausgewählte Strukturmerkmale, die hier aus vier Balkenfeldern und einem zentralen Kreuz bestehen, ist in Fig.1 dargestellt. Das Beispiel zeigt dabei 150nm-Stufen auf Si/SiO₂. Ein zentraler Ausschnitt dieser Strukturmerkmale dient als Erkennungsmuster, das in Fig.2 abgebildet ist. Ein entsprechendes Rasterbild auf Basis eines Soll-Datensatzes ist in einer Speichereinheit der Elektronenstrahllithographieanlage vorab abgespeichert worden und wird zur Positionsbestimmung des Wafers verwendet.

Bei der Bildaufnahme wird der Elektronenstrahl rasterförmig in x- und y-Richtung über den Wafer geführt. Hierbei wird schrittweise vorgegangen, wobei mit dem Elektronenstrahl eine Stempelkette mit gleichbleibender Schrittweite auf das Substrat aufgebracht wird. Die Schrittweite liegt dabei im Bereich von 20 nm bis 5 µm. Während des Aufbringens der Stempelkette werden mittels eines oder auch mehrerer Detektoren die reflektierten bzw. rückgestreuten Elektronen erfaßt. Die dabei gewonnenen Signalkurven werden analysiert und als digitalisiertes Rasterbild abgespeichert.

Zur Positionsbestimmung des Wafers wird nun mit Methoden der Bilddatenverarbeitung in dem aufgenommenen Rasterbild ein dem vorab abgespeicherten Erkennungsmuster entsprechendes Muster gesucht. Um ein solches Muster aufzufinden, muß dieses in dem Rasterbild enthalten sein, jedoch nicht notwendigerweise in dessen Zentrum liegen. Vielmehr ist es gerade die Aufgabe der Bilddatenverarbeitungssoftware, das Vorhandensein des Musters in dem Rasterbild zu erkennen und dessen Position zu ermitteln.

Bei Auffinden eines Musters wird dessen Lage in bezug auf eine Referenzposition bestimmt. Fig.1 zeigt ein Beispiel für ein Rasterbild, bei dem sich das gesuchte Muster links vom Zentrum des Rasterbildes befindet, wobei hier angenommen wird, daß die Referenzposition in der Bildmitte liegt. Die Bilddatenverarbeitungssoftware erkennt die tatsächliche Position des gesuchten Musters und gibt die entsprechenden Koordinaten an ein Positioniersystem, mit dem die Lageabweichung von der Referenzposition durch eine Relativbewegung zwischen dem Wafer und der Vorrichtung ausgeglichen wird. Vorzugsweise erfolgt dies durch Korrekturbewegungen eines Tisches, auf dem der Wafer zum Zwecke der Bestrahlung abgelegt ist. Die Korrekturbewegungen können sowohl translatorisch in zwei Koordinatenrichtungen als auch rotatorisch erfolgen.

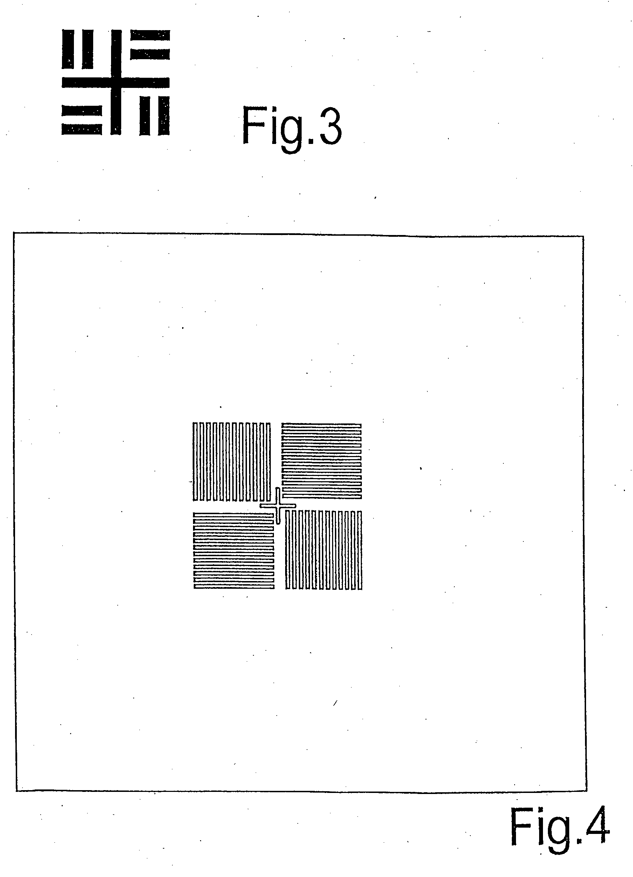

Fig.4 zeigt ein Kontrollbild nach einem Ausgleich der Lageabweichung, bei dem sich das gesuchte Muster und damit die erste Marke im Zentrum des Rasterbildes, d. h. in der hier angenommenen Referenzposition befindet. Durch die Bestimmung der Position von mehreren Flächenabschnitten mit charakteristischen Strukturmerkmalen kann die Abweichung des Wafers von einer Sollposition in mehreren Koordinaten bestimmt werden. Dazu werden von den Abschnitten des Wafers, in denen die jeweiligen Strukturmerkmale vermutet werden, in der vorstehenden Art und Weise Rasterbilder generiert und die Abweichungen in bezug auf die jeweilige Referenzposition ermittelt.

Es ist dabei nicht unbedingt erforderlich, daß nach der Ermittlung der Lageabweichung sofort ein Ausgleich derselben vorgenommen wird. Vielmehr kann aus den ermittelten Positionen der Strukturmerkmale eine Relativbewegung hinsichtlich Translation und Rotation ermittelt werden.

Die Positionsbestimmung, die auf der Aufnahme jeweils eines kompletten Rasterbildes beruht, arbeitet mit einem Global-Alignment-Algorithmus mit Bilderkennung, dem eine zweidimensionale Korrelation zugrunde liegt. Dieser Algorithmus wird weiter unten noch näher erläutert. Spezielle Vorselektionsverfahren dienen dazu, die Rechenzeit gering zu halten. So beträgt die Zeit für die Bildaufnahme inklusive Transferzeit zu einem Baugruppenrechner (VMEAX) je nach Bildpunktzahl etwa 5 bis 20 Sekunden. Das gesamte Global-Alignment, bestehend aus Anfahren eines Flächenabschnittes mit Strukturmerkmalen, Bildaufnahme und Rechenzeit dauert ca. 20 Sekunden pro Rasterbild. Die Auflösung des Korrelationsverfahrens liegt bei Subpixel-Genauigkeit.

Die Erfindung ist nicht auf das vorstehend erläuterte Verfahrensbeispiel beschrankt. Vielmehr können auch andere als die in den Figuren dargestellten Geometrien verwendet werden.

Möglich ist auch die Verwendung von ursprünglich für photolithographische Stepper vorgesehenen Global-Alignment-Marken, die in der beschriebenen Weise mit der Elektronenstrahllithographie-Anordnung erkannt werden können. Dies ist insbesondere dann vorteilhaft, wenn das vorstehend erläuterte Verfahren in einem Mix-und-Match-Verfahren verwendet wird, bei dem Photolithographie und Elektronenstrahllithographie wechselnd zum Einsatz kommen.

Anstelle von gesondert auf den Wafer aufgebrachten geometrischen Strukturen können auch bereits an dem Wafer vorhandene charakteristische Strukturen oder Strukturausschnitte verwendet werden. Charakteristisch ist eine Struktur dann, wenn diese in einem größeren Umgebungsbereich, der etwa dem Suchfeld entspricht, sich nicht nochmals wiederfindet.

In Vorbereitung des Global-Alignments wird eine typische Bildeinzelheit, beispielsweise eine auf den Wafer aufgebrachte Markierung oder aber auch charakteristischer Strukturabschnitt als Erkennungsmuster deklariert. Hierzu bestehen mehrere Möglichkeiten.

Eine erste Möglichkeit liegt darin, das Erkennungsmuster mittels eines ausgewählten Wafers anzulernen. Hierzu werden der Wafer und die Vorrichtung, ggf. unter wiederholter Aufnahme eines Rasterbildes, so lange relativ zueinander verschoben, bis sich der ausgewählte Strukturabschnitt in der Referenzposition, d. h. hier im Zentrum des Rasterbildes befindet. In dieser Position des Wafers wird dann in der oben bereits erläuterten Art und Weise ein Rasterbild aufgenommen und dieses oder auch lediglich ein Ausschnitt desselben als Erkennungsmuster abgespeichert. Fig.2 zeigt einen solchen Ausschnitt aus einem Rasterbild, der etwa 1/5 des Rasterbildes umfaßt. Die Kantenlängen des hier dargestellten quadratischen Erkennungsmusters betragen jeweils 120 µm.

Liegen die ausgewählten Strukturmerkmale bzw. das Erkennungsmuster aus der Entwicklungsphase des betreffenden Layers elektronisch gespeichert vor, so kann man alternativ auch mit einem Grafikprogamm eine entsprechende Darstellung erzeugen und diese in das Format des Rasterbildes übersetzen. Fig.3 zeigt ein Beispiel für eine solche grafische Darstellung in Analogie zu dem in Fig.2 dargestellten Erkennungsmuster.

Bei größeren Rasterbildformaten ist es vorteilhaft, wenn bei dem Aufsuchen der Strukturmerkmale der entsprechende Flächenabschnitt an dem Wafer in Mikrofelder zerlegt wird. Diese werden dann jeweils mit dem Ablenksystem des Elektronenstrahls zeilenweise rasterförmig abgetastet. Zur Weiterschaltung zwischen den Mikrofeldern kann zusätzlich das Positioniersystem der Elektronenstrahllithographieanlage verwendet werden. Ein solches feldweises Vorgehen erlaubt eine schnelle Bilderfassung durch effizientes Anfahren der einzelnen Scanpunkte.

Bevor eine Analyse der Bilddaten erfolgt, werden die Mikrofelder zu einem Gesamtbild zusammengesetzt. In diesem Gesamtbild erfolgt dann das Aufsuchen des Erkennungsmusters bzw. diesem entsprechende Strukturmerkmale.

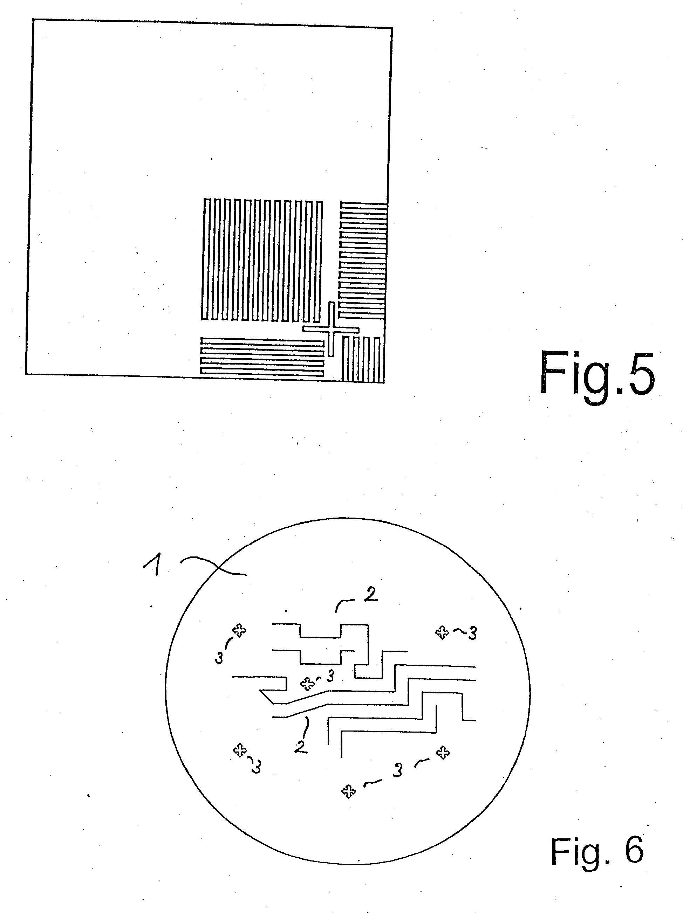

Fig. 6 zeigt in schematischer Weise einen Wafer 1 mit Strukturen 2, die elektronische Schaltkreise oder mechanische Strukturen darstellen. Zudem sind Global-Alignment-Marken 3 dargestellt, die für das Ausrichten des Wafers 1 bei der photolithographischen Belichtung benötigt werden. Erfindungsgemäß werden die Strukturen 2 bzw. charakteristische Strukturmerkmale der Strukturen 2 oder auch die für die photolithographische Belichtung vorhandenen Global-Alignment-Marken 3 für das Ausrichten des Wafers 1 in der Elektronenstrahlbelichtungsanlage genutzt. Es können somit die bisher auf dem Wafer 1 aufgebrachten speziellen Global-Alignment-Marken (in Fig. 6 nicht dargestellt) entfallen, die ausschließlich dem Zweck der Ausrichtung des Wafers bei der elektronenstrahllithographischen Belichtung dienten.

Im Folgenden wird nun zur weiteren Erläuterung ein konkretes Beispiel zur zweidimensionalen Bildauswertung anhand einer entsprechenden Software wiedergegeben, die bei einer Elektronenstrahlbelichtungsanlage ZBA 31(k) der Firma Leica Mircosystems Lithography GmbH genutzt wird.

Mit dem Hintergrund der Erweiterung der Möglichkeiten des Global-Alignments auf vorstrukturierten Wafern bzw. Masken innerhalb der CAL-Software der Elektronenstrahlbelichtungsanlage ZBA31 (K) erfolgte die Einbindung neuer Funktionen zur zweidimensionalen Aufnahme und Abspeicherung von Rückstreuelektronenbildern und eines Algorithmus zum Suchen jeweils einer markanten Struktur (des Referenzbildes) innerhalb eines im Verhältnis zu dieser Referenzstruktur größeren Suchbildes. In diesem Zusammenhang wurde auch die Syntax der Global-Alignment Description Files (GDF) weiter ausgebaut.

Die Meßfunktion (glkmes) der Bildaufnahme kann auch zur Gewinnung beliebiger zweidimensionaler RE- oder Justierdetektorsignale (2D-Sweeps) genutzt werden. Sie ist automatisch mit einer Visualisierung der gewonnen Bilddaten gekoppelt.

Die vor allem zur Testung der grundlegenden Abläufe der zweidimensionalen Bildaufnahme genutzten Funktionen tafswp und oldmes gehören ebenfalls noch zu den verfügbaren SCM-Funktionen. Sie werden hier nur kurz dokumentiert. Für den Test des innerhalb von GDF_glocos genutzten Algorithmus der Bildauswertung wurden die beiden auch einzeln im SCM nutzbaren Funktionen pctr_lcmp und pctr_test ergänzt.

Allgemeine Grundlagen der 2D-Bildaufnahme:

Die in die CAL-Software implementierte Bildaufnahme erlaubt z. Z. die Abspeicherung zwei-dimensionaler quadratischer Pixelbilder mit einem Datenumfang von 30*30 Pixeln bis maximal 600*600 Pixeln (pctr_anz). Die Größe des Bildes kann von 3*3 µm² bis maximal 1700*1700 µm² gewählt werden (pctr_dim). Die sich daraus ergebende Schrittweite darf 5 µm nicht überschreiten, die Mindestschrittweite beträgt 20 nm, d. h. es ist nicht jede beliebige Kombination der Parameter pctr_anz und pctr_dim möglich (z. B. kann die maximale Größe des Bildes bei 200*200 Meßpunkten (pctr_anz = 200) nur 1 mm betragen (pctr_dim = 1000), bei 600*600 Meßpunkten beträgt die Mindestbildgröße 12 µm). Die Bildaufnahme erfolgt immer symmetrisch zur aktuellen Tischposition (d. h. die Bildmitte entspricht der Position des unausgelenkten Elektronenstrahls an der jeweiligen Tischposition). Die eigentliche Gewinnung der Meßwerte erfolgt ähnlich wie bei einem eindimensionalen Sweep über den Signalkanal (DSP SIC).

Es wird eine Stempelkette in X-Richtung mit der erforderlichen Schrittweite organisiert und diese mit der gleichen Schrittweite in negative Y Richtung versetzt wiederholt, bis insgesamt eine quadratische Fläche mit dem Microkanal abgerastert ist. Pro Stempel wird jeweils ein Pixelwert abgespeichert. Dabei können maximal 60*60 Pixel pro Microfeld (SWF - sub work field) abgerastert werden. Das Gesamtbild setzt sich, wenn erforderlich, aus maximal 30*30 Microfeldern zusammen, deren Mittelpunkte mit dem Macroablenksystem angesteuert werden. Die einzelnen Pixelwerte können mit swpACC durch Wiederholung jeweils des gesamten Microfeldes gemittelt werden. Die Abrasterung Kann nur mit einem quadratischen Strahlformat vorgenommen werden. Die Eingabe erfolgt immer mit swpfm, das orthogonale Format swpfmo wird automatisch auf diesen Wert gesetzt.

Register und Funktionen zur Aufnahme, Abspeicherung und Weiterverarbeitung der 2D-Bilddaten:

Name des ZBA Picture Data Files (ZPD): pctr_name < S80: ohne Extension > Größe des Pixel-Bildes in X und Y [µm]: pctr_dim, < G: 3, ..., 1700 > Anzahl der Pixel in X und in Y : pctr_anz < G: 30, ..., 600 >

Aufruf: glkmes "picture file" [GLK_FCT]

Eingabe: pctr_name, swpfm, pctr_dim, pctr_anz, swpACC

Ausgabe: uln, pctr_name, pctr_dim, pctr_anz, usn, swpfmo, rststep, rstline, SIC_cadr, SIC_RAM, SIC_crtyp

Mit dieser Funktion können an der aktuellen Tischposition zweidimensionale Pixelbilder auf dem Justierdetektor (swpadw = "JU4" oder "JU5") oder in Summenschaltung auf einem beliebigen Objekt (swpadw = "SUM") aufgenommen und als ZBA Picture Data File (ZPD) im Verzeichnis ZBA31$CalProt: unter dem Namen pctr_name.ZPD abgespeichert werden. Danach erfolgt automatisch eine Visualisierung des Bildes, verbunden mit einer Kommentarausgabe der wichtigsten Bild- und Sweep-Parameter. Die gemessenen Bilder sind immer quadratisch und werden symmetrisch zur Tischposition aufgenommen. Die Anzahl der Bildpunkte in X- und in Y-Richtung wird mit pctr_anz festgelegt, die Größe des Bildes in [µm] in pctr_dim und das verwendete Strahlformat mit swpfm (swpfmo = swpfm). Die Mittelung der Pixelwerte eines abgerasterten Microfeldes kann wie beim Microsweep mit swpACC festgelegt werden (swpACC=2ⁿ, n= 0, ..., 7; d.h.swpACC=1, ..., 128).

Anhand der gewählten Parameter pctr_dim und pctr_anz erfolgt automatisch die Berechnung der notwendigen Schrittweite in X- und in Y-Richtung (swpstep = rststep), der innerhalb eines Microfeldes notwendigen Sweeplänge (swplen) in X-Richtung, der Anzahl der in negativer Y-Richtung jeweils versetzten Rasterlinien eines Microfeldes (rstline) und der Anzahl der zum Zusammensetzen des gesamten Bildes notwendigen Microfelder (SWF). Im Gegensatz zu normalen Sweeps sind bei der Bildaufnahme beliebige Schrittweiten (ganzzahlige Vielfache von 20 nm) bis zu einer maximalen Schrittweite von 5 µm zulässig und auch eine geringe Stempelanzahl von mindestens 9 Stempel pro Rasterlinie sind erlaubt. Die sich ergebenden Werte werden zum Teil als Ausgabeparameter der Funktion glkmes im SCM angezeigt und sind bei der Visualisierung aus dem Kommentarblock oder den Loggingauschriften ersichtlich. Die 3 letzten Ausgabeparameter geben die Adresse und den RAM-Typ der abgespeicherten Daten eines Microfeldes im DSP SIC an (Testparameter der Programmentwicklung).

Bei der Wahl der Anzahl der Bildpunkte (pctr_anz) ist zu beachten, daß für weniger als 120 Pixel nur geradzahlige Werte zulässig sind (d. h.: 30, 32, 34, ..., 120), für Werte von 120 bis 600 nur ganzzahlige Vielfache von 10 (d. h.: 120, 130, 140, ..., 590, 600).

Der Kommentarblock eines ZPD-Files hat bei fehlerfreier Meßwertaufnahme das folgende, an einem Beispiel dargestellte Aussehen:
all 144 SWF measurements successful
S: swptakt 51, swplen 50000 nm, swpstep 1000 nm, GAIN 472
Swp: fm/fmo 720 720, sadw SUM, 0x23 0x70101, O/ILS 2170 624
Pctr: pctr_dim 600 mim, rststep 1000 nm, 50 lines per SWF
Pctr: 360000 pixel, 12*12 SWFs, 2500 (2550) pixel per SWF
Pctr: min/max 88/124 [49/124 ?], 600*600 pixel, ACC 4, w 51

Aufgrund der Bildgröße von 600 µm (pctr_dim) und der Anzahl von 600*600 Werten wurde eine Rasterschrittweite von 1 µm (swpstep = rststep = 1000 nm) ermittelt. Das Gesamtbild mit insgesamt 360.000 Pixeln setzt sich aus 12*12 Microfeldern (SWF) zusammen. Die Sweeplänge innerhalb eines Feldes beträgt 50 µm (swplen =50.000 nm), es werden in X-Richtung 51 Sweepstempel (swptakt) und in Y-Richtung 50 Rasterlinien (rstline) organisiert. Der jeweils erste Wert jeder Rasterlinie wird bei der Abspeicherung der Pixelwerte ignoriert, so daß sich insgesamt 2500 Werte pro Microfeld (SWF) ergeben. Die Meßwertaufnahme in dem Beispiel erfolgte mit einem Format von 720*720 nm² (swpfm = swpfmo) in Summenschaltung (swpadw = "SUM") mit den SAB-Parametern saGAIN = 472, saOLS = 2170 und salLS = 624. Die Sweepsteuerworte waren auf sactrl = 0x23 bzw. swpctrl = 0x70101 gesetzt. Die Mittelung erfolgte mit swpACC = 4 und die Verzögerung der einzelnen Stempel mit swpwait = 51. Das Minimum aller abgespeicherten Pixelwerte betrug 88, das Maximum 124.

Aus programmtechnischen Gründen sollte die Aufnahme der Meßwerte mit einem gegenüber dem normalen Sweep höheren swpwait von ca. 40 bis 60 durchgeführt werden, damit man besonders an den Nahtstellen der Microfelder keine zu großen Schwankungen in den Pixelwerten bekommt. Dies wird in der Regel innerhalb von glkmes automatisch organisiert. Wenn der Wert kleiner als 5 ist, wird mit swpwait = 51 gearbeitet. Der default-Wert von swpwait beträgt bisher 2 und wird bei kost_ini automatisch gesetzt

Während der Aufnahme zweidimensionaler Bilder wird keine Regelung der Verstärkung (saGAIN) und Verschiebung (saOLS, salLS) des Meßsignals vorgenommen. Erfolgt die Messung mit swpadw = "JU4" oder "JU5", d. h. auf dem Justierdetektor, so wird mit den aktuell eingestellten Werten für saGAIN, saOLS und salLS gearbeitet. Diese stehen in der Regel bereits von den vorhergegangen Sweeppositionierungen auf optimalen Werten. Es erweist sich als günstig, wenn man dabei mit dem gleichen quadratischem Sweepformat arbeitet wie bei der späteren Bildaufnahme.

Erfolgt die Messung auf einem beliebigen Objekt in Summenschaltung mit swpadw = "SUM", so muß man zuvor dafür sorgen, daß ein CMP-File unter dem Namen GLK_PCTR.CMP im Verzeichnis DISK$ZBA31_K:[GS.SWP]existiert, in dem die Parameter saREK, saSAL und saSBL manuell oder mit dem DCL-Kommandofile SA_PAR.COM richtig angepaßt wurden. Aus diesen Werten errechnen sich dann in Abhängigkeit von dem verwendeten Sweepformat und dem aktuell eingestellten Strahlstrom die Einstellwerte von saGAIN, saOLS, salLS und sactrl. Hierbei sind einige Besonderheiten zu beachten:
Das Laden des CMP-Files und die Berechnung verschiedener Parameter kann mit der Bitmaske 40.000 im SCM-Register testconf unterdrückt werden.
Die Unterscheidung, ob der File GLK_PCTR.CMP geladen und ausgewertet wird, hängt von dem vor dem Aufruf aktuell eingestellten Wert von swpadw ab (SCM-Register). Sollte das Register swpadw ebenfalls in GLK_PCTR.CMP enthalten sein, so muß dort ebenfalls die Summenschaltung (SUM) als Registerwert stehen.
Enthält der CMP-File die Register swpfm und swpfmo (diese werden z. B. von SA_PAR dort eingetragen), so sollten deren Werte mit dem gewünschten quadratischen Format der Bildaufnahme übereinstimmen. Der Wert von swpfmo spielt keine Rolle, für die sich anschließende Bildaufnahme wird swpfmo = swpfm gesetzt. Die Formatwerte im CMP-File haben Vorrang gegenüber dem im SCM gewählten Eingabeparameter swpfm. Das gleiche trifft für swpACC zu.
Da bei der zweidimensionalen Bildaufnahme keine eigentliche CMP-Kurve benötigt wird und der File GLK_PCTR.CMP nur zum Laden der Sweep-Parameter genutzt wird, kann auf die eigentlichen Werte einer CMP-Kurve fast vollständig verzichtet werden. Aus programmtechnischen Gründen muß der File GLK_PCTR.CMP nach der Kennung #compare_values genau einen beliebigen Wert (z. B. eine 0) enthalten. In dem Fall werden auf zu wenig CMP-Werte hinweisende Fehlermeldungen unterdrückt und es erfolgt kein Laden in den DSP SIC. Das gleiche trifft für alle CMP-Files zu, die über den GDF-File ausgewählt werden.
Das Fehlen der Register saREK, saSAL oder saSBL in den besonderen CMP-Files führt zu einer Fehlermeldung und zum Abbruch der Bildaufnahme.

Der erste bei glkmes verwendete Ausgabeparameter uln enthält immer die Gesamtanzahl der gemessenen Pixelwerte (pctr_anz²) oder eine 0 bei nicht durchgeführter Bildaufnahme aufgrund von Fehlern bei der Vorbereitung der Messung (Parameterüberprüfung, CMP-File laden, ...). Er steht zusammen mit dem Filenamen pctr_name aus programmtechnischen Gründen an erster Stelle, damit sicher gestellt ist, daß die Visualisierung am Steuerrechner nur nach erfolgter Bildaufnahme durchgeführt wird.

Für Testzwecke besteht die Möglichkeit, die Grenzen der Microfelder (SWF) in den Bilddaten sichtbar zu machen. Dies wird mit dem Setzen des nicht direkt zu den Eingabeparametern von glkmes gehörenden Registers usn = 17 vorgenommen. In dem Fall wird der jeweils letzte Wert einer Rasterlinie und die gesamte letzte Rasterlinie des Microfeldes auf einen konstanten Wert gesetzt, der bei der Visualisierung zu einem deutlich sichtbaren Linienraster führt. Der Wert von usn wird am Ende auf 1 gesetzt, d. h. die Aktivierung der SWF-Linien wirkt jeweils nur einmal

Aufruf: pctr_lcmp "load compare picture" [GLK_FCT]

Eingabe: pctr_name

Ausgabe: usn, uln, rststep

Diese Funktion dient zum Laden eines zuvor mit glkmes abgespeicherten ZBA Picture Data Files (ZPD-File im Verzeichnis ZBA31$CalProt) als Referenzbild für die mit pctr_test durchführbare Suche einer markanten Marke (s. nächster Funktionsaufruf). Als Referenzbild können nur Datenfiles mit maximal 120*120 Werten (pctr_anz) genutzt werden. Es erfolgt keine Visualisierung des geladenen Bildes, lediglich die wesentlichen Parameter der Bildaufnahme werden im Logging ausgegeben und als Ausgabeparameter übernommen. In usn wird pctr_dim und in uln wird pctr_anz des Referenzbildes angezeigt, zusätzlich wird die sich daraus ergebende Schrittweite des Bildes in rststep (= swpstep) mit ausgegeben.

Aufruf: pctr_test "test function" [GLK_FCT ]

Eingabe: pctr_name, string, swpfm, pctr_dim, pctr_anz, swpACC

Ausgabe: uln, pctr_name, rststep, rstline, swpfmo, string, pctr_dim, pctr_anz, swpx, swpy, dx, dy, swpFC

Die innerhalb des Global-Alignments genutzte Suche einer markanten Markenstruktur innerhalb eines im Verhältnis zu diesem Referenzbild größeren Suchbildes kann mit pctr_test auch unabhängig von einem vollständig ablaufenden GDF_glocos getestet werden. Es wird vorausgesetzt, daß zuvor mit pctr_lcmp ein geeignetes Referenzbild geladen wurde. Die Bildauswertung kann mit einem bereits abgespeicherten Suchbild (string = "load") oder einem neu aufzunehmenden Suchbild gleicher Schrittweite (string = "auto" (!= "load" entspricht "auto")) vorgenommen werden. Beim Laden eines bereits abgespeicherten Bildes werden die Eingabeparameter swpfm, pctr_dim, pctr_anz und swpACC mit den Werten aus dem ZPD-File überschrieben. Wird das Suchbild neu aufgenommen, so haben diese Parameter die gleiche Bedeutung wie in der auch intern genutzten Funktion glkmes. Innerhalb von pctr_test können nur Bilder mit mindestens 120*120 Pixeln (pctr_anz) aufgenommen werden. Kleinere Werte im Register pctr_anz werden automatisch auf 120 gesetzt.

Vor dem Beginn der eigentlichen Bildauswertung wird kontrolliert, ob ein geeignetes Referenzbild zuvor geladen wurde und ob die Rasterschrittweite des Referenzbildes identisch mit der des Suchbildes ist. Der Algorithmus der Bildauswertung erfordert das Einhalten gewisser Randbedingungen, die in einem späteren Gliederungspunkt separat zusammengefaßt sind.

Als Ergebnis einer fehlerfreien Bildsuche wird der Versatz der Mitte des Referenzbildes zur Mitte des Suchbildes in [nm] in den Registern dx und dy und ein Qualitätsmaß für die Sicherheit des erzielten Ergebnisses in swpFC angegeben. Je größer das Qualitätsmaß ist (auf jeden Fall größer als 1.1), um so größer ist die Sicherheit der Eindeutigkeit der Suche der Referenzstruktur innerhalb des Suchbildes. Bei Testauswertungen mit realen Waferbildern lag dieser Wert in der Regel zwischen 5 und 20, wobei auch kleinere Werte (größer 1.3) zufriedenstellende Ergebnisse lieferten.

Unabhängig davon, ob das Bild geladen oder neu gemessen wurde, erfolgt am Ende eine Visualisierung des Suchbildes, in gleicher Weise wie in der oben beschriebenen Funktion glkmes.

Aufruf: oldmes "micro or macro" [GLK_FCT ]

Eingabe: pctr_name, string, radx, stepx, fx, fy

Ausgabe: uln, pctr_name, string, radx, stepx, stab_min, stab_max

Hierbei handelt es sich um eine Testfunktion, mit der uln Meßwerte durch Einzelmessung mit der Funktion sadw_mes über den Siganlkanal entsprechend der Wahl in swpadw aufgenommen, in einem ZPD-File abgespeichert und visualisiert werden. Die Strahlauslenkung kann wahlweise mit dem Micro-(string = "micro") oder dem Macro-Ablenksystem (string = "macro") vorgenommen werden. Die Größe des Bildes wird ähnlich wie bei cenmes durch die Parameter radx und stepx (beide gelten auch in Y-Richtung) festgelegt (5 # radx # 299). Die Anzahl der Bildpunkte in X- und in Y-Richtung beträgt ((2 * radx) + 1). Die Bildaufnahme erfolgt immer symmetrisch zur aktuellen Tischposition, die Bildmitte entspricht dem unausgelenktem Strahl, d. h. mx = my = hx = hy = 0. Bei der Wahl der Schrittweite ist zu beachten, daß mit (radx * stepx) nicht die Grenzen des gewählten Ablenksystems (mx, my bzw. hx, hy) überschritten werden dürfen.

Die Einstellung der Verstärkung saGAIN und der Verschiebungen salLS und saOLS muß manuell an das verwendete Strahlformat von fx * fy (inkrementell) angepaßt werden. Aufgrund der Einzelansteuerung jeder Meßposition kann besonders bei der Auswahl des Macro-Ablenksystems die Meßzeit sehr lang werden. Man sollte sich deshalb mit einem kleinen Wert beginnend (radx = 5) langsam an die gewünschte Bildgröße herantasten. Das Minimum und das Maximum aller gemessenen AD-Wandlerwerte (entspricht sadw_val) wird in den beiden Ausgabeparametern stab_min und stab_max übermittelt.

Aufruf: tafswp "test 2D sweep" [SWEEP_FCT]

Eingabe: swpx, swpy, swplen, swpstep, rstline, rststep, pctr_name

Ausgabe: uln, swperr, swpMIN, swpMAX, swpMH, swplen, swpstep, swptakt, SIC_cadr, SIC_RAM, SIC_crtyp

Mit der Funktion tafswp kann die Meßfunktion zur zweidimensionalen Abrasterung eines Microfeldes getestet werden. Alle erforderlichen Schrittweiten, die Sweeplänge zur Vorgabe der Pixelanzahl in X-Richtung und die Anzahl der Rasterlinien in negativer Y-Richtung müssen als Eingabeparameter bereitgestellt werden. Die Funktion tafswp kann nur mit swpdir = 0 und gesetzter Bitmaske 4 in testconf aufgerufen werden. Der testconf-Wert verhindert die automatische Anpassung von swplen und swpstep an normale Sweep-default-Werte und ermöglicht die Angabe beliebiger Sweep-Schrittweiten als ganzzahlige Vielfache von 5 nm. Die Bitmaske 4 ist nach den Aufrufen der Funktion tafswp unbedingt wieder zu löschen, weil dadurch die von vielen SEQ- und DCL-Kommandofiles erwartete automatische Anpassung von swplen und swpstep unterdrückt wird.

Die Sweep-Ausgabewerte swpMIN, swpMAX und swpMH entsprechen den vom DSP SIC übergebenen Werten. Die Parameter SIC_cadr, SIC_RAM und SIC_crtyp ermöglichen es, die uln = (rstline * swptakt) im DSP SIC abgespeicherten vorzeichenlosen Pixelmeßwerte (8 Bit) mit der Funktion store_cbl auszulesen und als ASCII-Tabelle unter einem festen Filenamen STO-RE_CBLOCK_nnn.DAT im Verzeichnis ZBA31$CALPROT: abzuspeichern.

Setzt man den Eingabeparameter pctr_name = "tafswp", so werden die (rstline * swptakt) Pixelwerte automatisch aus dem DSP SIC ausgelesen, als ZBA Picture Data File TAFSWP.ZPD im Verzeichnis ZBA31$CALPROT: abgespeichert und im Anschluß grafisch dargestellt.

Visualisierung gespeicherter ZBA Picture Data Files (ZPD-Files):

Befindet sich das Programm VISUREM.EXE im Verzeichnis ZBA31$SYSTEM:, so kann man bereits abgespeicherte ZPD-Files zu einem späteren Zeitpunkt in gleicher Weise wie nach dem SCM-Aufruf der Funktion glkmes visualisieren. Dafür sind folgende Schritte innerhalb eines beliebigen DecTerm-Fensters des Steuerrechners notwendig:
1. Definition eines Symbols, gewöhnlich REM, in folgender Weise (nur einmalig notwendig):
   CAL> REM == "$ZBA31$SYTEM:VISUREM"
2. Start des Programmes VISUREM über das Symbol REM mit Angabe der vollständigen ZPD-File-Spezifikation:
   CAL> REM ZBA31$CALPROT:WAFER_TEST.ZPD

In ähnlicher Weise kann man mittels des Programmes REMTOBMP.EXE, e-benfalls im Verzeichnis ZBA31$SYSTEM:, abgespeicherte ZPD-Datenfiles in ein für die Weiterverarbeitung am PC geeignetes BMP-Format konvertieren, oder sich mit dem Programm REMTOASC.EXE einen Textfile (ASCII-Format) der abgespeicherten Binärdaten erzeugen lassen. Dies geschieht in folgender Weise:
CAL> RTB == "$ZBA31$SYSTEM:REMTOBMP"
CAL> RTA == "$ZBA31$SYSTEM:REMTOASC"
CAL> RTB ZBA31$CALPROT:WAFER_TEST.ZPD
CAL> RTA ZBA31$CALPROT:WAFER_TEST.ZPD

Der dabei erzeugte BMP-File WAFER_TEST.BMP enthält keinen Kommentarblock mehr. Dieser wird parallel in einem Textfile WAFER_TEST.BXT abgespeichert. In dem Listingfile WAFER_TEST.LIS wird der gesamte Kommentarblock übernommen, beginnend mit einem Ausrufezeichen (!) jeweils pro Zeile. Die Pixelwerte werden in pctr_anz Zeilen zu je pctr_anz Spalten eingetragen. Die Ausgabe erfolgt dezimal mit 3 Feststellen und einem Leerzeichen als Trennzeichen. Dadurch können bereits bei pctr_anz > 62 Zeilen mit mehr als 256 Zeichen pro Zeile entstehen, was bei der Wahl eines geeigneten Editors zu berücksichtigen ist.

Erweiterungen innerhalb des Global-Alignment Description Files (GDF):

Die Einbindung der 2D-Bildauswertung in den Gesamtablauf des Global-Alignments (Funktionen GDF_glocos und beam_glk) machte eine Erweiterung der bisherigen Eingabemöglichkeiten des GDF-Files erforderlich. Die Liste der möglichen Einfangmarken wurde um den Markentyp PICTURE ergänzt, der in den 3 Modifikationen

| | | | |
|---|---|---|---|
| PICTURE | position-X | position-Y | n |
| P_PICTURE | position-X | position-Y | n |
| und F_PICTURE | position-X | position-Y | n |

verwendet werden kann. Dieser Markentyp erfordert wie bisher 2 Positionsangaben in µm, bezogen auf die Mitte der aufzunehmenden Suchbilder (Realwerte mit maximal 2 Stellen nach dem Komma) und die Angabe hier nur einer Nummer (n, Integerwert) des zu nutzenden Filenamens (cmp_namen). Die Größe des jeweiligen Suchbildes und der Umfang der Pixeldaten werden mit den auch im GDF-File genutzten Registern
#pctr_dim Integerwert ! Bildgröße in µm in X- und Y-Richtung
und #pctr_anz Integerwert ! Anzahl Bildpunkte in X- und Y-Richtung festgelegt. Beide Register können für jede verwendete Bildaufnahme neu festgelegt werden. Um entscheiden zu können, ob die aufgenommenen Suchbilder als ZPD-Datenfile abgespeichert werden sollen oder nicht, wurde ein weiteres nur im GDF-File verwendbares Register
#store_mod yes ! yes oder no möglich (default: no)
ergänzt. Die Suchbilder werden von der Funktion glkmes im Verzeichnis ZBA31$CALPROT: unter dem Namen cmp_namen_measuring.ZPD abgespeichert.

An den bisherigen mit dem Prefix 'F_' gekennzeichneten Einfangmarkentypen erfolgte keine Vorpositionierung. Da die Bildauswertung immer mit dem gesamten aufgenommenen Bild erfolgt, gibt es hier keine Unterscheidung zwischen PICTURE und F_PICTURE. Die Meßergebnisse der mit dem Prefix 'P_' beginnenden Bildmarken (P_PICTURE) werden wie bisher nicht in die am Ende vorgenommene Berechnung der Tischtransformation mit einbezogen.

Die neuen Möglichkeiten des GDF-Files können mit den bisherigen für Sweep-Messungen geeigneten Einfangmarken kombiniert werden. Eine typische Anwendung ist die Nutzung der Bildauswertung zu einer groben Vorpositionierung, besonders an Marken, die aufgrund ihrer Umgebung keine Grobsuche mit Sweeppositionierungen zulassen. Im Anschluß kann eine Feinpositionierung an bisherigen Markentypen mit den dort üblichen Sweep-Messungen erfolgen.

Die Bildauswertung beruht auf der Suche einer markanten Struktur (Referenzbild) innerhalb eines großen neu aufzunehmenden Suchbildes. Dazu werden die bereits aufgeführten Funktionen glkmes, pctr_lcmp und pctr_test verwendet. Der Ablauf erfordert das vorherige Laden eines CMP-Files zur Festlegung der bei der Bildaufnahme genutzten Sweep-Parameter und das Laden eines vorher bereitzustellenden Referenzbildes mit der mittig positionierten Markenstruktur. Die Auswahl der dafür notwendigen Filenamen wird über den dritten Parameter n (s. oben) einer PICTURE-Marke vorgenommen, was voraussetzt, daß das Register vorher z. B. mit dem Namen test_picture in der Form:
#cmp_namen test_picture
festgelegt wurde. In dem Fall muß im Verzeichnis DISK$ZBA31_K:[GS.SWP]: der File TEST_PICTURE.CMP mit den für die Bildaufnahme notwendigen Sweep-Parametern swpfm (swpfmo = swpfm), swpACC, saREK, saSAL, saSBL und swpadw = "SUM" existieren und im Verzeichnis ZBA31$CALPROT: ein Referenzbild unter TEST_PICTURE.ZPD abgespeichert sein (aufgenommen mit glkmes).
Es ist wichtig, daß die bei der Aufnahme des Referenzbildes verwendete Schrittweite identisch ist mit der durch pctr_dim und pctr_anz festgelegten Schrittweite des Suchbildes.

Die genauere Nutzung soll im weiteren anhand eines konkreten Beispiels erläutert werden. Da die Genauigkeit der Positionskorrektur abhängig von der durch die Parameter pctr_dim und pctr_anz festgelegten Schrittweite ist, werden in dem Beispiel beide Positionen jeweils doppelt genutzt, jedoch beim zweiten mal mit einer feinerer Schrittweite und kleiner Bildabmessung. Dazu muß auf jeden Fall auch ein zweites dazu passendes Referenzbild existieren, was in dem Beispiel ebenfalls verdeutlicht werden soll. Die bereits nach der zweiten PICTURE-Marke vorgenommene und für weitere Positionierungen genutzte Grobkorrektur der Eichung und Drehung ist ausreichend, um die in der Referenzstruktur enthaltene CROSS-Marke mit weiteren herkömmlichen Sweeps zu vermessen. Die dabei gewonnenen Korrekturen werden zur Bestimmung der Tischtransformation genutzt:
! GDF-Muster mit 2D-Bildauswertung und anschließender Sweep-Messungen
#cmp_name cross ! für F_CROSS
#cmp_name3 picture_grob ! für P_PICTURE ...x ...y 3
#cmp_name5 picture_fein ! für P_PICTURE ...x ...y 5
#init_mod yes ! Beginn mit glk_init
#cmvtx 850.00 !Startverschiebung X in µm
#cmvty -1100.00 ! Startverschiebung Y in µm
! neue Picture Parameter
#store_mod yes ! Speichern von picture_grob_measuring.ZPD
! und picture_fein_measuring.ZPD
#pctr_dim 720 ! Suchbild 720 µm
#pctr_anz 600 ! 600*600 Pixel, Step 1200 nm
#P_PICTURE 0 32000.00 3 ! Referenzbild: picture_grob.ZPD
#P_PICTURE 0 -32000.00 3 ! S-Parameter: picture_grob.CMP
! Wiederholung mit feinerer Schrittweite
#pctr_dim 150 ! Suchbild 150 µm
#pctr_anz 300 ! 300*300 Pixel, Step 500 nm
#P_PICTURE 0 -32000.00 5 ! Referenzbild: picture_fein.ZPD
#P_PICTURE 0 32000.00 5 ! S-Parameter: picture_fein.CMP
!Beginn mit Sweep-Messungen
#cmradx 40.00 ! 40 µm, -> Sweep-Vorauslenkung 20 µm
#cmrady 40.00
#F_CROSS 0 32000.00 0 ! CMP-Kurve: cross.cmp
#F_CROSS 0 -32000.00
! --- end of --- MUSTER_PICTURE.GDF --- !

Das für die ersten beiden Bildauswertungen genutzte Referenzbild PICTURE_GROB.ZPD muß mit einer Schrittweite von 1,2 µm aufgenommen sein und sollte aufgrund der Größe des Suchbildes von 600*600 Bildpunkten möglichst von der maximalen Größe 120 eines Referenzbildes sein (z. B. pctr_anz = 120, pctr_dim = 144). Das zweite Referenzbild PICTURE_FEIN.ZPD mit einer Schrittweite von 500 nm kann z. B. mit pctr_dim = 40 und pctr_anz = 80 aufgenommen worden sein. Die beiden CMP-Files PICTURE_GROB.CMP und PICTURE_FEIN.CMP können identisch sein, müssen jedoch aus programmtechnischen Gründen genau unter diesen Namen existieren. Wichtig ist, daß vor allem die jeweils zugehörigen Referenzbilder mit den gleichen Sweep-Parametern swpfm, saREK, saSAL und saSBL aufgenommen wurden, damit die Kontrastverhältnisse sich nicht deutlich von denen der aufgenommenen Suchbilder unterscheiden.

Der Algorithmus wird zur Suche einer markanten Marke, d. h. einer eindeutig erkennbaren 2-dimensionalen Bildstruktur innerhalb eines im Verhältnis zu dieser Referenzstruktur größeren Suchbildes genutzt. Er stellt gewisse Anforderungen an das Aussehen der Marke:
- die zu suchende Markenstruktur muß eindeutig sein, d. h. es dürfen sich keine gleichartigen Strukturen in der Umgebung befinden, möglichst auch keine ähnlichen
- die Marke muß flächenhaft ausgeprägt sein, d. h. bei Verkleinerung des Bildes auf ein Drittel in X- und in Y-Richtung muß die Marke noch eindeutig als solche erkennbar sein,
- das Referenz- und Suchbild sollten ein gutes Signal-Rausch-Verhältnis besitzen und annähernd den gleichen Kontrast aufweisen
- die Marke sollte einige homogene Bereiche mit einer Ausdehnung von mindestens 10 * 10 Pixeln aufweisen, dieser Anteil sollte 25 % der Gesamtfläche betragen,
- das Verhältnis von Referenzbild zu Suchbild sollte in einer Koordinatenrichtung 1 zu 2 bis maximal 1 zu 5 betragen (entspricht dem Verhältnis von pctr_anz).

An dieser Stelle sei als Beispiel eine 120 µm große Referenzmarke mit einer Pixelanzahl von 120* 120 Werten dargestellt (Schrittweite 1000 nm), die bei der Testung der Bildauswertung zur Suche in dem ebenfalls dargestellten Bild von 600 * 600 Pixeln genutzt wurde:
Referenzbild (pctr_anz = 120, pctr_dim = 120, swpfm = swpfmo = 720, min = 90, max = 125) siehe Fig.2;
Suchbild (pctr_anz = 600, pctr_dim = 600, swpfm = swpfmo = 720, min = 87, max = 123) siehe Fig.5.

## Patentansprüche

1. Verfahren zum Belichten eines aus mehreren Ebenen (Layern) bestehenden Layouts auf einem Wafer, bei dem mindestens eine Ebene photolithographisch und darauf folgend mindestens eine weitere Ebene mit einem Elektronenstrahl belichtet wird und der Wafer bezüglich der vorher photolithographisch belichteten Ebene definiert zur Elektronenstrahlbelichtungsanlage auszurichten ist, wobei der Wafer zunächst grob so zur Elektronenstrahlbelichtungsanlage positioniert wird, daß sich ein Flächenabschnitt der photolithographisch belichteten Ebene, der ausgewählte Strukturmerkmale enthält, im Ablenkbereich des Elektronenstrahles befindet, **dadurch gekennzeichnet, dass**
- der Flächenabschnitt in x- und y-Richtung spotweise mit dem Elektronenstrahl mit gleichbleibender Schrittweite abgetastet wird,
- die von den einzelnen Spots rückgestreute Strahlung detektiert und aus den Intensitäten der von den einzelnen Spots rückgestreuten Strahlung ein Ist-Datensatz gewonnen wird, der als ein Rasterbild dieses Flächenabschnittes bei der Ist-Position des Wafers gespeichert wird,
- der Ist-Datensatz mit einem gespeicherten Soll-Datensatz verglichen wird, der dem Rasterbild desselben Flächenabschnittes bei Soll-Position des Wafers entspricht wobei im Flächenabschnitt charakteristische Strukturmerkmale im Rasterbild des Ist-Datensatzes mit Methoden der Bilddatenverarbeitung gesucht und deren Positionen ermittelt werden,
- aus der Abweichung der ausgewählten charakteristischen Strukturmerkmale der beiden Datensätze voneinander Informationen über die Abweichung der Ist-Position von der Soll-Position abgeleitet werden,
- anhand dieser Informationen eine Positionsveränderung des Wafers zwecks Annäherung der Ist-Position an die Soll-Position veranlaßt wird.

2. Verfahren nach Anspruch 1, bei dem die Gewinnung des Ist-Datensatzes und der Vergleich mit dem Soll-Datensatz und die Positionsänderung des Wafers sooft wiederholt werden, bis keine Abweichung mehr feststellbar ist.

3. Verfahren nach Anspruch 1 oder 2, bei dem der Soll-Datensatz mittels eines bereits belichteten Wafers gewonnen wird, wobei zunächst der Wafer und die Elektronenstrahlbelichtungsanlage solange relativ zueinander verschoben werden, bis sich die ausgewählten Strukturmerkmale in der gewünschten Soll-Position befinden und anschließend ein dem Rasterbild des Flächenabschnittes mit diesen Strukturmerkmale entsprechender Soll-Datensatz (Template) erfaßt und gespeichert wird.

4. Verfahren nach Anspruch 1 oder 2, bei dem der Soll-Datensatz aus digitalen Layoutdaten der elektronisch vorliegenden Strukturdaten der photolithographisch zu belichtenden Ebene entnommen und gespeichert wird.

5. Verfahren nach Anspruch 4, wobei die Geometrie der elektronisch vorliegenden Strukturdaten mit einem Grafikprogramm generiert und in das elektronenoptisch abgetastete Format des Rasterbildes übersetzt wird.

6. Verfahren nach einem der vorgenannten Ansprüche, wobei beim spotweisen Abtasten der Flächenabschnitt in Mi-krofelder aufgeteilt wird, die einzeln nacheinander abgetastet und zwecks Auswertung zu einem Gesamtbild zusammengesetzt werden.

7. Verfahren nach einem der vorgenannten Ansprüche, bei dem als ausgewählte Strukturmerkmale verschiedenste Strukturen genutzt werden, die ursprünglich nicht zur Ausrichtung für die Elektronenstrahlbelichtung auf den Wafer aufgebracht worden sind.

8. Verfahren nach einem der vorgenannten Ansprüche, bei dem als ausgewählte Strukturmerkmale beliebige charakteristische Strukturen aus einer Ebene, die bereits zuvor auf dem Wafer belichtet wurde, genutzt werden, wobei wenigstens der Bereich in unmittelbarer Umgebung des abgetasteten Flächenabschnitts frei von ähnlichen Strukturen ist.

9. Verfahren nach einem der vorgenannten Ansprüche, bei dem der für die Positionsbestimmung des Wafers spotweise abgetastete Flächenabschnitt mit einer Spotrasterschrittweite im Bereich von ein Zwanzigstel bis ein Tausendstel der Abmessungen des Flächenabschnitts abgetastet wird.

10. Verfahren nach einem der vorgenannten Ansprüche, bei dem nach Erreichen der Übereinstimmung des Ist-Datensatzes mit dem Soll-Datensatz eine Feinausrichtung des Wafers anhand von auf dem Wafer vorhandenen feineren Justiermarken vorgenommen wird.

## Claims

1. A method for exposing a layout comprising multiple layers on a wafer, wherein at least one layer is photolithographically exposed, followed by exposure of at least one further layer with an electron beam, and the wafer is to be aligned with respect to the previously photolithographically exposed layer in a manner defined with respect to the electron beam exposure system, said wafer first being positioned coarsely with respect to the electron beam exposure system in such a way that a surface area of the photolithographically exposed layer that contains selected structural features is located in the deflection region of the electron beam, **characterized in that**
- the surface area is scanned in the X and Y direction in spot fashion with the electron beam at a constant step size;
- the radiation backscattered from the individual spots is detected, and from the intensities of the radiation backscattered from the individual spots an actual data set is obtained that is stored as a raster image of that surface area with the wafer in the actual position;
- the actual data set is compared to a stored reference data set that corresponds to the raster image of the same surface area with the wafer in the reference position, characteristic structural features in the surface area being searched for in the raster image of the actual data set, and their positions being determined, by methods of image data processing;
- from the deviation between the selected characteristic structural features of the two data sets, information is derived as to the deviation between the actual position and the reference position;
- on the basis of that information, a positional change of the wafer is caused in order to bring the actual position closer to the reference position.

2. The method according to claim 1, wherein the obtaining of the actual data set and the comparison with the reference data set and the positional change of the wafer are repeated until no further deviation is ascertained.

3. The method according to claim 1 or 2, wherein the reference data set is obtained by means of a wafer that has already been exposed, the wafer and the electron beam exposure system first being displaced relative to one another until the selected structural features are located in the desired reference position, and a reference data set (template) corresponding to the raster image of the surface area having those structural features then being acquired and stored.

4. The method according to claim 1 or 2, wherein the reference data set is taken from digital layout data of the electronic structural data of the layer that is to be exposed photolithographically, and is stored.

5. The method according to claim 4, wherein the geometry of the structural data present in electronic form is generated using graphics software and is translated into the electron-optically scanned format of the raster image.

6. The method according to any one of the preceding claims, wherein during scanning in spot fashion, the surface area is divided into micro-fields that are scanned individually and sequentially and, for purposes of analysis, assembled into an overall image.

7. The method according to any one of the preceding claims, wherein various structures not originally applied onto the wafer to effect alignment for electron beam exposure are utilized as the selected structural features.

8. The method according to any one of the preceding claims, wherein any characteristic structures from a layer already previously exposed on the wafer are utilized as the selected structural features, with at least the region in the immediate vicinity of the scanned surface area being free from similar structures.

9. The method according to any one of the preceding claims, wherein the surface region scanned in a spot fashion to determine the position of the wafer is scanned with a spot raster step size ranging from one twentieth to one thousandth of the dimensions of the surface area.

10. The method according to any one of the preceding claims, wherein after agreement has been achieved between the actual data set and the reference data set, a fine alignment of the wafer is performed on the basis of finer alignment marks present on the wafer.

## Revendications

1. Procédé d'exposition d'un arrangement comportant plusieurs couches sur une tranche, ce procédé comprenant l'exposition photolithographique d'au moins une couche et puis l'exposition d'au moins une couche additionnelle par un faisceau d'électrons, et l'alignement de ladite tranche, par rapport à la couche déjà soumise à l'exposition photolithographique, d'une manière définie par rapport au système d'exposition par faisceau d'électrons, ladite tranche étant d'abord positionnée approximativement par rapport au système d'exposition par faisceau d'électrons de sorte qu'une région de surface de la couche soumise à l'exposition photolithographique qui contient des particularités structurelles sélectionnées se trouve dans la région de déviation du faisceau d'électrons,
**caractérisé en ce que**
- ladite région de surface est balayée d'un spot à l'autre par le faisceau d'électrons en direction de X et de Y avec un pas constant;
- le rayonnement rétrodiffusé par les spots individuels est détecté et un ensemble de données réelles est obtenu à partir des intensités du rayonnement rétrodiffusé par les spots individuels, cet ensemble de données étant mémorisé sous forme d'un image matricielle de ladite région de surface lorsque la tranche se trouve dans sa position réelle;
- une comparaison est effectuée entre l'ensemble de données réelles et un ensemble de données de consigne mémorisé qui correspond à l'image matricielle de la même région de surface lorsque la tranche se trouve dans la position de consigne, en cherchant des particularités structurelles caractéristiques dans la région de surface dans l'image matricielle de l'ensemble de données réelles et déterminant leurs positions par des méthodes de traitement de données d'image;
- des informations sur la déviation entre la position réelle et la position de consigne sont dérivées à partir de la déviation entre les particularités structurelles caractéristiques sélectionnées des deux ensembles de données;
- un changement de position de la tranche est effectué à partir de ces informations pour réaliser une approximation de la position réelle à la position de consigne.

2. Procédé selon la revendication 1, dans lequel l'obtention de l'ensemble de données réelles et leur comparaison avec l'ensemble de données de consignes et le changement de position de la tranche sont répétés jusqu'à ne plus pouvoir constater aucune déviation.

3. Procédé selon la revendication 1 ou 2, dans lequel l'ensemble de données de consigne est obtenu au moyen d'une tranche déjà exposée, en déplaçant d'abord, l'une par rapport à l'autre, la tranche et le système d'exposition par faisceau d'électrons jusqu'à ce que les particularités structurelles sélectionnées se trouvent dans la position de consigne désirée, et en saisissant et mémorisant ensuite un ensemble de données de consigne (template) correspondant à l'image matricielle de la région de surface présentant ces particularités structurelles.

4. Procédé selon la revendication 1 ou 2, dans lequel l'ensemble de données de consigne est obtenu à partir de données de mise en page digitales des données structurelles sous forme électronique de la couche destinée à l'exposition photolithographique et est mémorisé.

5. Procédé selon la revendication 4, dans lequel la géométrie des données structurelles sous forme électronique est engendrée à l'aide d'un logiciel graphique et est convertie dans le format de l'image matricielle balayé par optique électronique.

6. Procédé selon l'une quelconque des revendications précédentes, dans lequel, pendant le balayage d'un spot à l'autre, la région de surface est divisée dans des micro-champs qui sont balayés individuellement, l'un après l'autre, et sont assemblés de manière à constituer une image intégrale permettant une analyse.

7. Procédé selon l'une quelconque des revendications précédentes, dans lequel des structures diverses qui n'étaient pas initialement appliquées sur la tranche pour un alignement dans le but de l'exposition par faisceau d'électrons sont utilisées en tant que particularités structurelles sélectionnées.

8. Procédé selon l'une quelconque des revendications précédentes, dans lequel n'importe quelles particularités structurelles d'une couche déjà exposé précédemment sur la tranche sont utilisées en tant que particularités structurelles sélectionnées, et dans lequel au moins la région au voisinage immédiat de la région de surface balayée ne présente pas des structures semblables.

9. Procédé selon l'une quelconque des revendications précédentes, dans lequel la région de surface balayée d'un spot à l'autre pour déterminer la position de la tranche est balayée en utilisant un pas de la grille des spots compris entre un vingtième et un millième des dimensions de ladite région de surface.

10. Procédé selon l'une quelconque des revendications précédentes, dans lequel, ayant atteint l'identité entre l'ensemble de données réelles et l'ensemble de données de consigne, on effectue un alignement fin de la tranche à partir de repères d'alignement plus fins qui existent sur la tranche.
